# DEMANDE DE BREVET EUROPEEN

(11) **EP 4 632 398 A1**
(43) Date de publication de la demande: **15.10.2025**
(21) Numéro de dépôt: 25166257.3
(22) Date de dépôt: 26.03.2025
(51) Int. Cl.: G01R 31/3185, G01R 31/319

(54) **CIRCUIT ELECTRONIQUE DE TEST D'UN CIRCUIT NUMERIQUE**

(30) Priorité: 09.04.2024 FR 2403632
(71) Demandeur: STMicroelectronics International N.V., 1228 Plan-les-Ouates, Geneva (CH)
(72) Inventeur: SCHALCK-SCHMITT, Jean-Paul, 38500 VOIRON (FR)
(74) Mandataire: Cabinet Beaumont

(57) **Abrégé**

La présente description concerne un circuit électronique de test (200) d'un circuit numérique (104,110), comprenant un multiplexeur (310) ayant : une première entrée (A) destinée à recevoir un signal du circuit numérique à tester ; une deuxième entrée (Te) configurée pour recevoir un signal d'activation de mode de test (Scan_mode) ; une troisième entrée (Ti) ; une première sortie (Z) destinée à recevoir un état de la troisième entrée (Ti) lorsque la deuxième entrée (Te) est activée et un état de la première entrée (A) lorsque la deuxième entrée (Te) est désactivée ; une deuxième sortie (NSZ) destinée à recevoir un état du signal présent sur la première entrée (A) ou être mise à zéro lorsque la deuxième entrée (Te) est respectivement activée ou désactivée.

## Description

### Domaine technique

La présente description concerne de façon générale les circuits électroniques de test de circuits numériques.

### Technique antérieure

Les circuits électroniques, comme par exemple les circuits numériques, doivent pouvoir être testés pendant la fabrication ou lors de la vie du circuit. Pour cela, des parties de circuits de tests sont développés conjointement aux circuits à tester (design for test en anglais).

### Résumé de l'invention

Il existe un besoin d'obtenir un circuit de test capable de tester un maximum de signaux du circuit numérique associé.

Un mode de réalisation pallie tout ou partie des inconvénients des circuits de test connus.

Un mode de réalisation prévoit un circuit électronique de test d'un circuit numérique, comprenant un multiplexeur ayant :
- une première entrée destinée à recevoir un signal du circuit numérique à tester ;
- une deuxième entrée configurée pour recevoir un signal d'activation de mode de test ;
- une troisième entrée ;
- une première sortie destinée à recevoir un état de la troisième entrée lorsque la deuxième entrée est activée et un état de la première entrée lorsque la deuxième entrée est désactivée ;
- une deuxième sortie destinée à recevoir un état du signal présent sur la première entrée ou être mise à zéro lorsque la deuxième entrée est respectivement activée ou désactivée.

Un mode de réalisation prévoit un circuit électronique de test d'un signal numérique, le circuit électronique comprenant un circuit de sélection de signal ayant :
- une première entrée destinée à recevoir un signal du circuit numérique à tester ;
- une deuxième entrée configurée pour recevoir un signal d'activation de mode de test ;
- une troisième entrée ;
- une première sortie destinée à recevoir un état de la troisième entrée lorsque la deuxième entrée est activée et un état de la première entrée lorsque la deuxième entrée est désactivée ;
- une deuxième sortie destinée à recevoir un état du signal présent sur la première entrée lorsque la deuxième entrée est activée et être mise à zéro lorsque la deuxième entrée est désactivée.

Selon un mode de réalisation, l'état du signal présent sur la deuxième sortie est issu d'une fonction logique de type ET entre l'état du signal d'activation de test et l'état du signal présent sur la première entrée (A) du multiplexeur.

Selon un mode de réalisation, le circuit de test comprend une bascule de balayage comprenant :
- un étage de multiplexage ayant :
   une première entrée reliée à la deuxième sortie du multiplexeur,
   une deuxième entrée configurée pour recevoir l'état du signal d'activation de mode de décalage,
   une troisième entrée,
   une sortie destinée à recevoir l'état du signal présent sur la première entrée de l'étage de multiplexage lorsque sa deuxième entrée est dans un premier état et recevoir l'état du signal présent sur la troisième entrée de l'étage de multiplexage lorsque sa deuxième entrée est dans un deuxième état ; et
- une bascule de type D dont une entrée de donnée est reliée à la sortie de l'étage de multiplexage.

Selon un mode de réalisation, la première sortie du multiplexeur est reliée à un bloc analogique et l'état du signal sur la troisième entrée du multiplexeur est maintenu à un état constant, bas ou haut, au moins lorsque le mode de test est activé.

Selon un mode de réalisation, la première entrée du multiplexeur est reliée à une sortie d'une cellule de synchronisation et la troisième entrée du multiplexeur est destinée à recevoir un signal de test de réinitialisation généré à l'extérieur du bloc numérique.

Selon un mode de réalisation, la première sortie du multiplexeur est reliée à une sortie d'un bloc de division de signal d'horloge et la troisième entrée du multiplexeur destinée à recevoir un signal de test d'horloge généré à l'extérieur du bloc numérique.

Selon un mode de réalisation, le multiplexeur comprend une première et une deuxième branches reliant chacune un premier nœud à un deuxième nœud ;
la première branche étant composée de :
   deux premiers transistors PMOS en série entre le premier nœud et un troisième nœud,
   deux premiers transistors NMOS en série entre le troisième nœud et le deuxième nœud, et
   un deuxième transistor PMOS en série avec un deuxième transistor NMOS, un nœud de conduction du deuxième transistor PMOS étant relié à un nœud de conduction commun aux deux premiers transistors PMOS, et un nœud de conduction du deuxième transistor NMOS étant relié à un nœud de conduction commun aux deux premiers transistors NMOS;
la deuxième branche étant composée de deux troisièmes transistors PMOS en série entre le premier nœud et le troisième nœud, et deux troisièmes transistors NMOS en série entre le troisième nœud et le deuxième nœud ;
le multiplexeur comprenant en outre un quatrième transistors PMOS reliant le premier nœud à un nœud de conduction commun aux deuxièmes transistors PMOS et NMOS.

Selon un mode de réalisation, le multiplexeur comprend un premier circuit inverseur configuré pour fournir un état inverse de l'état du signal d'activation de mode de test sur :
le nœud de commande d'un des premiers transistors NMOS reliant le troisième nœud au nœud de conduction commun aux deux premiers transistors NMOS,
le nœud de commande du deuxième transistors PMOS, et
le nœud de commande du troisième transistor PMOS qui est relié au troisième nœud.

Selon un mode de réalisation, le multiplexeur comprend un deuxième circuit inverseur reliant le nœud de conduction, commun aux deuxièmes transistors PMOS et NMOS, et la deuxième sortie.

Selon un mode de réalisation, le multiplexeur comprend un troisième circuit inverseur reliant le troisième nœud et la première sortie.

Selon un mode de réalisation, le nœud de commande d'un des premiers transistors PMOS ayant un nœud de conduction relié au premier nœud, et le nœud de commande d'un des premiers transistors NMOS ayant un nœud de conduction relié au deuxième nœud sont destinés à recevoir l'état du signal présent sur la première entrée du multiplexeur.

Selon un mode de réalisation,
le nœud de commande d'un des premiers transistors PMOS ayant un nœud de conduction relié au troisième nœud,
le nœud de commande du quatrième transistor PMOS,
le nœud de commande d'un des troisièmes transistors NMOS relié au troisième nœud, et
le nœud de commande du deuxième transistor NMOS,
sont destinés à recevoir l'état du signal d'activation de test.

Selon un mode de réalisation, le nœud de commande d'un des troisièmes transistors PMOS dont un nœud de conduction est relié au premier nœud et le nœud de commande d'un des troisièmes transistors NMOS relié au deuxième nœud, sont destinés à recevoir l'état du signal présent sur à la troisième entrée du multiplexeur.

Selon un mode de réalisation, l'état du signal présent sur la troisième entrée du multiplexeur est issu d'un générateur de vecteurs de test.

Selon un mode de réalisation, le circuit électronique de test et le circuit numérique sont agencés sur une même puce.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente très schématiquement sous forme de blocs un exemple de circuit intégré du type auquel s'applique les modes de réalisation ;
la figure 2 représente très schématiquement un exemple d'un circuit de la figure 1;
la figure 3 représente un exemple d'un circuit de la figure 1 selon un mode de réalisation ;
la figure 4 représente de façon schématique un circuit de la figure 3 selon un mode de réalisation ;
la figure 5 représente de façon schématique un circuit de la figure 1 selon un mode de réalisation ;
la figure 6 représente de façon schématique un circuit de la figure 1 selon un mode de réalisation ; et
la figure 7 représente de de façon schématique un circuit de la figure 1 selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

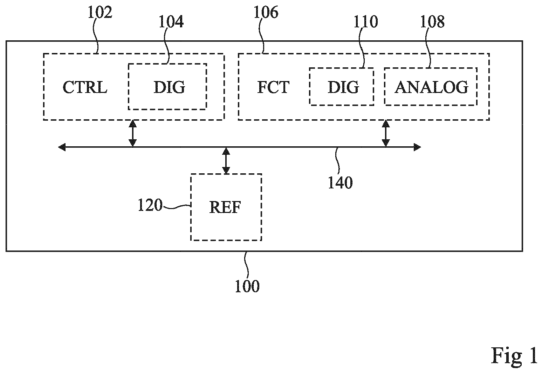

La figure 1 représente très schématiquement sous forme de blocs un exemple de circuit intégré 100 du type auquel s'applique les modes de réalisation.

Le circuit 100 comprend par exemple une unité de traitement 102 (CTRL) comprenant un ou plusieurs processeurs par exemple sous contrôle d'instructions stockées dans une mémoire d'instructions (non illustrée).

Le circuit 100 comprend en outre un module 120 (REF) ayant un bloc de génération de signal d'horloge de référence comprenant un oscillateur générant une fréquence de référence.

Le circuit 100 peut intégrer d'autres circuits mettant en œuvre d'autres fonctions (par exemple, une ou plusieurs mémoires volatiles et/ou non-volatiles, d'autres unités de traitement, une interface d'entrée/sortie I/O), symbolisées par un bloc 106 (FCT) en figure 1.

Les blocs 102, 106 et 120, sont par exemple reliés entre eux et/ou au reste du circuit intégré 100 par l'intermédiaire d'un bus 140 véhiculant les signaux requis.

Le module 106 ou les blocs 102 et/ou 120 comprennent en outre par exemple d'autres blocs fonctionnels.

Les blocs 102, 106 et/ou le bloc 120 comprennent par exemple un ou des circuits numériques représentés sous forme de blocs 104,110 (DIG). Le bloc 106, ou bien chacun des blocs 102,106,120 comprennent par exemple également des parties 108 (ANALOG) dédiées à un fonctionnement analogique et qui sont par exemple en communication avec les blocs numériques respectifs.

Il existe un besoin de tester les circuits numériques 104,110 que ce soit lors de la fabrication ou lors de la vie du circuit 100. Les défauts ou fautes ou erreurs peuvent être testés s'il existe une procédure bien spécifiée pour l'exposer dans le silicium réel. Pour ce faire, des circuits de tests sont conçus et par exemple intégrés dans le circuit 100 pour tester des signaux des circuits 104,110. Cela permet d'observer des nœuds internes pour que les fonctions embarquées puissent également être testées.

Les défauts ou fautes détectables sont par exemple le collage d'un signal a une valeur donnée (0 ou 1), une erreur de logique, ou encore une erreur de fréquence d'horloge.

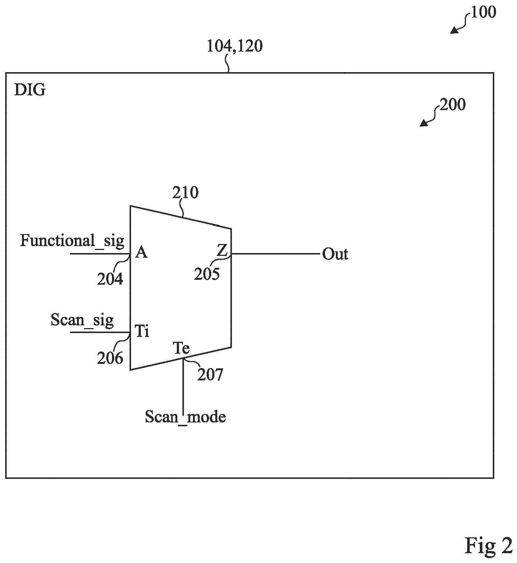

La figure 2 représente très schématiquement un exemple d'un circuit 210 de la figure 1.

Plus particulièrement, le circuit 210 est un multiplexeur faisant partie d'un circuit de test 200 d'un des circuits numériques 104,110.

Dans l'exemple représenté, le multiplexeur 210 est placé en série sur un chemin à tester du circuit numérique 104,110 de sorte à recevoir sur une entrée un signal à tester (Functional_sig) et à avoir une sortie Z,205 reliée au reste du circuit numérique 104,110.

Le multiplexeur 210 comprend une première entrée A,204 qui est placée dans le circuit 104,110 pour recevoir un état d'un signal Functional_sig du circuit numérique à tester.

Le multiplexeur 210 comprend en outre une deuxième entrée Te, 207, destinée à recevoir un état d'un signal Scan_mode qui, selon sa valeur active ou désactive le passage du circuit 104,110 à un mode de test.

Le multiplexeur 210 comprend également une troisième entrée Ti,206 configurée pour recevoir un état d'un signal de test Scan_sig. En d'autres termes, le signal Scan_sig remplacera le signal à tester Functional_sig lorsque la deuxième entrée sera activée par le signal Scan_mode. Le signal Scan_sig pourra prendre différentes formes selon la nature du signal Functional_sig à tester.

La sortie Z,205 est configurée pour recevoir l'état du signal Scan_sig lorsque la deuxième entrée Te est activée et un état du signal Functional_sig de la première entrée A,204 lorsque la deuxième entrée Te est désactivée. Le signal Out sur la sortie Z,205 se propage ensuite vers le reste du circuit numérique.

Dans le texte, une entrée activée signifie qu'elle reçoit un signal à l'état haut (ou 1) et désactivée signifie qu'elle reçoit un signal à l'état bas (ou 0). Il est néanmoins possible d'implémenter une solution inverse.

Le signal Out se retrouve ensuite dans la suite du circuit numérique et son état peut être stocké dans une bascule pour permettre son observation lors du test. Afin de pouvoir observer l'effet du remplacement du signal Functional_sig par le Signal_sig, les bascules (Flip Flop en anglais) qui font parties du circuit 104,110 sont d'un type différent de bascules standards. Ces bascules, dites testées (scanned en anglais) peuvent être placées dans un mode de test ou mode de balayage (scan mode en anglais) lorsque le signal Scan_mode est à l'état haut par exemple pour que l'état du signal qu'elles ont stocké puisse être observé sur leur sortie lors d'un coup de signal d'horloge postérieur. Dans le mode de test, toutes les bascules qui peuvent être testées sont mises en série, la sortie d'une bascule étant reliée ou connectée à une entrée de test (Ti) de la suivante, de sorte à former un registre à décalage. En injectant un vecteur de test approprié (c'est-à-dire une série de 0 ou 1 chacun séparés d'un coup d'horloge) dans la chaîne formée des bascules en série pendant le mode de test, il est ainsi possible de tester si des fautes sont présentes sur différentes portions du circuit. Ces vecteurs de tests peuvent être par exemple calculés avec un générateur automatique de vecteurs de tests (Automatic Test Pattern Generator en anglais).

Lorsque le test commence, le signal Scan_mode passe par exemple à l'état haut et le signal Scan_sig se retrouve sur la sortie Z,205. En faisant cela, il est possible de tester la suite du circuit connectée sur la sortie Z par exemple en simulant le signal Out attendu avec le signal Scan_sig ou en fixant ce signal à une valeur donnée.

Néanmoins, le signal Functional_sig n'est alors plus observé. Il en ressort que le taux de couverture des tests devient dans ce cas-là limité à moins de 70% pour le multiplexeur 210. L'objectif des conceptions de test étant d'atteindre une couverture de test proche ou supérieure à 99%, il est nécessaire d'envisager une solution pour augmenter cette couverture de test et notamment permettre l'observation de l'entrée A,204 pendant le mode de test.

Une solution pourrait consister à utiliser un deuxième multiplexeur supplémentaire, similaire au premier, mais avec l'entrée A du premier multiplexeur reliée, préférentiellement connectée, à l'entrée Ti du deuxième multiplexeur et l'entrée Ti du premier multiplexeur reliée, préférentiellement connectée, à l'entrée A du deuxième multiplexeur. Cela permettrait d'obtenir une observabilité de l'état du signal de l'entrée A,204 du premier multiplexeur à travers la sortie Z du deuxième multiplexeur.

Cependant, une telle solution nécessite une augmentation du nombre de transistors mis en oeuvre pour le test, ainsi qu'une augmentation de la surface de puce et de la consommation électrique. Dans un exemple, vingt-quatre transistors sont nécessaires pour mettre en oeuvre deux multiplexeurs 210.

De plus, dans cette solution, même si elle augmente la couverture de test, par exemple à environ 80% pour les deux multiplexeurs, elle ne permet pas d'atteindre la couverture à près de 99% qui est visée.

Pour pallier à ces problématiques, les modes de réalisation prévoient que le circuit électronique de test 200 du circuit numérique 104,110, comprenne un multiplexeur ayant :
- la première entrée A destinée à recevoir un signal du circuit numérique à tester ;
- la deuxième entrée Te configurée pour recevoir un signal d'activation de test ;
- la troisième entrée Ti ;
- la première sortie Z destinée à recevoir un état de la troisième entrée Ti lorsque la deuxième entrée Te est activée et un état de la première entrée A lorsque la deuxième entrée Te est désactivée ; et
- une deuxième sortie NSZ destinée à recevoir un état du signal présent sur la première entrée A ou être mise à zéro lorsque la deuxième entrée Te est respectivement activée ou désactivée.

L'état du signal sur la première entrée A étant accessible sur la nouvelle sortie NSZ lorsque le mode de test est activé, c'est à dire lorsque la deuxième entrée Te est activée, le taux de couverture de test est ainsi augmenté.

Cela permet de limiter la surface de puce consommée par rapport à une solution avec deux multiplexeurs 210 tout en augmentant la couverture de test à plus de 99% et en limitant la consommation.

Dans la suite du texte, le terme « multiplexeur » doit être compris comme un circuit de sélection de signal.

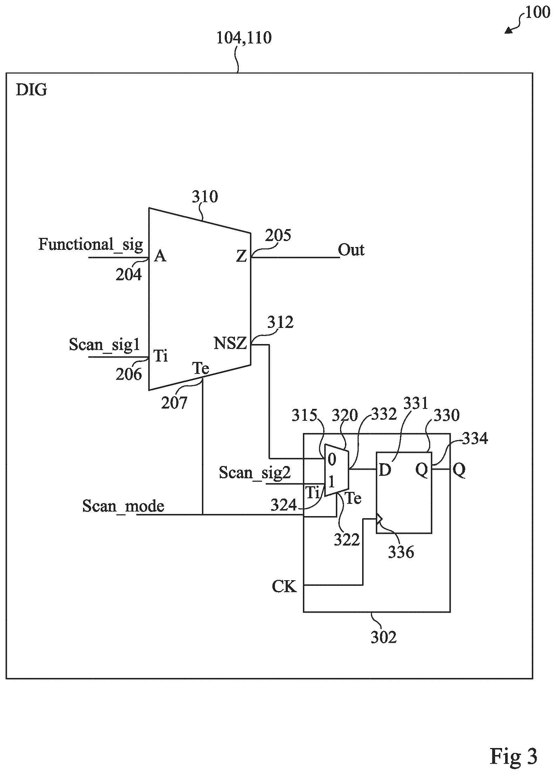

La figure 3 représente un exemple d'un circuit de la figure 1 selon un mode de réalisation.

Plus particulièrement, la figure 3 représente une partie du circuit de test 200 du circuit numérique 104,110.

Dans l'exemple représenté, le circuit de test 200 comprend un multiplexeur 310. Le multiplexeur 310 est similaire au multiplexeur 210 sauf qu'il comprend une sortie supplémentaire NSZ,312.

La sortie NSZ,312 est configurée pour d'une part recevoir un état du signal Functional_sig présent sur la première entrée A,204 lorsque la deuxième entrée Te est activée et d'autre part être mise à zéro lorsque la deuxième entrée Te est désactivée.

Dans un exemple, l'état du signal présent sur la deuxième sortie NSZ,312 est issu d'une fonction logique de type ET entre l'état du signal Scan_mode présent sur l'entrée Te,207 et l'état du signal présent sur la première entrée A,204 du multiplexeur 310.

Afin de pouvoir observer l'état du signal sur la deuxième sortie NSZ,312, cette dernière est reliée, préférablement connectée, à une bascule 302 qui peut être basculée dans un mode de test. Dans le reste du texte, les bascules qui peuvent être mises dans un mode de test sont appelées bascules de balayage.

Dans l'exemple représenté, la bascule de balayage 302 comprend un étage de multiplexage 320, autrement dit un multiplexeur 320, ayant une première entrée 315 configurée pour recevoir l'état du signal présent sur la deuxième sortie NSZ,312 du multiplexeur 310. L'étage de multiplexage 320 comprend également une entrée Te,322 configurée pour recevoir l'état du signalde décalage pendant le test de balayage. L'étage de multiplexage 320 comprend en outre une autre entrée 324 destinée à recevoir l'état d'un signal Scan_sig2.

L'étage de multiplexage 320 comprend en outre une sortie 332 configurée pour recevoir l'état du signal présent sur l'entrée 315 de l'étage de multiplexage 320 lorsque sa deuxième entrée 322 est dans un premier état, par exemple désactivée, et recevoir l'état du signal présent sur l'entrée 324 de l'étage de multiplexage 320 lorsque sa deuxième entrée 322 est dans un deuxième état, par exemple activée. Le premier état et le deuxième état peuvent être inversés selon les besoins.

Dans l'exemple représenté, la bascule de balayage 302 comprend en outre une bascule de type D,330 dont une entrée de donnée D,331 est reliée, préférentiellement connectée, à la sortie 332 de l'étage de multiplexage 320, une entrée d'horloge CP,336 est configurée pour recevoir un signal d'horloge CK et une sortie Q,334 configurée pour recevoir et conserver l'état de l'entrée D jusqu'au prochain coup d'horloge du signal CK. L'information du signal Functional_sig peut ainsi également être observée en sortie 334 de la bascule 330 lorsque le mode de test est en cours.

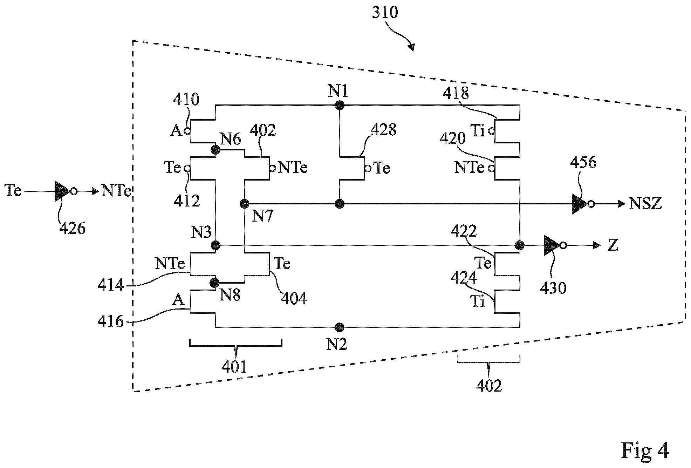

La figure 4 représente de façon schématique un circuit de la figure 3 selon un mode de réalisation. Plus particulièrement, la figure 4 représente un mode de réalisation du multiplexeur 310.

Dans l'exemple représenté, le multiplexeur 310 comprend une première branche et une deuxième branche 401,402 reliant chacune un premier nœud N1 à un deuxième nœud N2.

La première branche 401 est composée de deux premiers transistors PMOS 410,412 en série entre le premier nœud N1 et un troisième nœud N3. Elle est également composée de deux premiers transistors NMOS 414,416 en série entre le troisième nœud N3 et le deuxième nœud N2. La première branche 401 comprend en outre un deuxième transistor PMOS 402 en série avec un deuxième transistor NMOS 404. Un nœud de conduction du deuxième transistor PMOS 402 est relié à un nœud de conduction N6 commun aux deux premiers transistors PMOS 410,412. Un nœud de conduction du deuxième transistor NMOS 404 est relié à un nœud de conduction N8 commun aux deux premiers transistors NMOS 414,416.

La deuxième branche 402 est composée de deux troisièmes transistors PMOS 418,420 en série entre le premier nœud N1 et le troisième nœud N3, et deux troisièmes transistors NMOS 422,424 en série entre le troisième nœud N3 et le deuxième nœud N2.

Le multiplexeur 310 comprend en outre un quatrième transistor PMOS 428 reliant le premier nœud N1 à un nœud de conduction N7 commun aux deuxièmes transistors PMOS et NMOS 402,404.

L'état du signal sur l'entrée A se retrouve sur les nœuds de commande des transistors 410 et 416.

L'état du signal sur l'entrée Te se retrouve sur les nœuds de commande des transistors 404, 412, 422 et 428.

L'état du signal sur l'entrée Ti se retrouve sur les nœuds de commande des transistors 418 et 424.

Le circuit 200 comprend par exemple un inverseur 426 configuré pour fournir l'état inverse NTe du signal Scan_mode sur les nœuds de commande des transistors 414, 420 et 402. Dans un exemple, l'inverseur 426 est intégré au multiplexeur 310.

Dans l'exemple représenté, le multiplexeur 310 comprend en outre un inverseur 430 configuré pour fournir l'état inverse du signal présent sur le troisième nœud N3 vers la sortie Z,205.

Dans l'exemple représenté, le multiplexeur 310 comprend également un circuit inverseur 456 reliant le nœud N7 de conduction, commun aux deuxièmes transistors PMOS et NMOS 402,404, et la deuxième sortie NSZ.

Comme décrit dans l'exemple de la figure 2, dans le mode de test, toutes les bascules, y compris la bascule 302, sont mises en série, dans le mode de balayage à décalage (scan shift), la sortie d'une bascule étant reliée ou connectée à une entrée de test Ti de la suivante, de sorte à former un registre à décalage.

Le multiplexeur de la figure 4 comprend dix sept transistors ce qui est bien plus faible que le nombre de transistors nécessaires dans la solution à deux multiplexeurs.

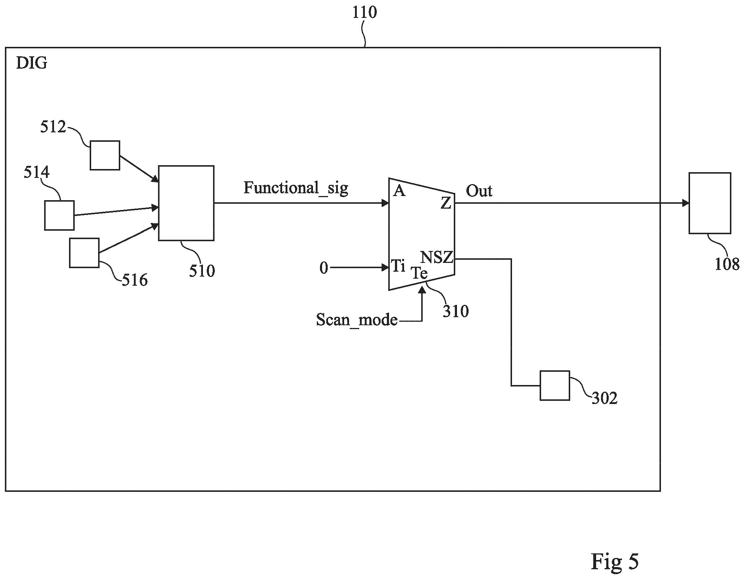

La figure 5 représente de façon schématique un circuit de la figure 1 selon un mode de réalisation. Plus particulièrement, la figure 5 représente un exemple de mise en oeuvre du multiplexeur 310.

Dans l'exemple représenté, le circuit numérique 110 est relié, préférablement connecté, au circuit analogique 108.

Dans ce cas-là, afin de protéger le circuit 108 lors du mode de test, l'entrée Ti,206 reçoit le signal Scan_sig qui est à un niveau donné par exemple 0. Ce niveau 0 se retrouve sur la sortie Z et le circuit 108 est ainsi protégé.

Dans l'exemple de la figure 5, le signal Functional_sig est par exemple issu d'un bloc de logique combinatoire relié, préférablement connecté, en entrée à par exemple trois bascules 512,514 et 516.

Lorsque le mode de test est activé, le signal Functional_sig est observable sur la bascule de balayage 302.

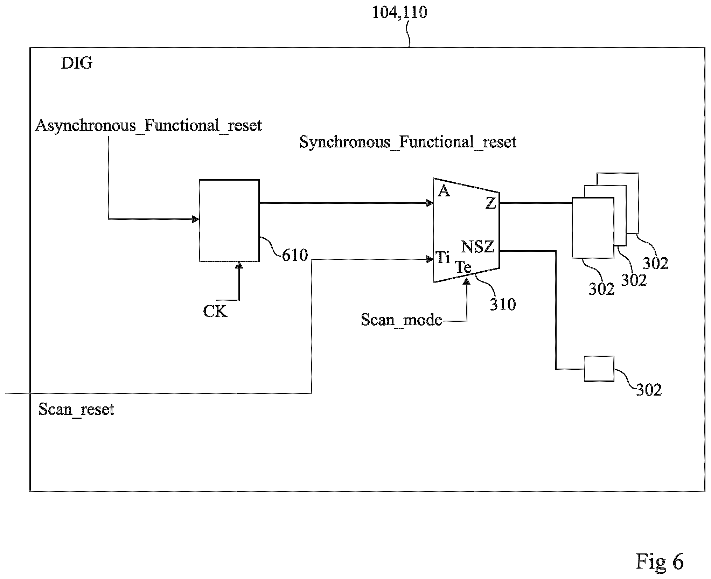

La figure 6 représente de façon schématique un circuit de la figure 1 selon un mode de réalisation. Plus particulièrement, la figure 6 représente un autre exemple de mise en oeuvre du multiplexeur 310.

Dans l'exemple représenté, le signal reçu sur l'entrée A,204 est issu d'une cellule 610 de resynchronisation de signal de réinitialisation.

Cette cellule de resynchronisation est par exemple composée de deux ou plus bascules D en série et ayant leurs entrées de réinitialisation (Reset en anglais) connectées ensemble et recevant un signal de réinitialisation qui peut être désynchronisé Asynchronous_Functional_reset. En sortie de cette cellule 610, le signal de réinitialisation Synchronous_Functional_reset est resynchronisé pour être distribué à une ou plusieurs bascules similaires à la bascule de balayage 302. Dans cet exemple, le signal Synchronous_Functional_reset est, dans cet exemple, le signal Functional_sig. L'entrée A,204 du multiplexeur 310 reçoit le signal de réinitialisation Synchronous_Functional_reset.

Lorsque le mode de test est activé, un signal de réinitialisation Scan_reset, similaire à celui fourni par une cellule d'alimentation par réinitialisation (Power On Reset cell en anglais) et synchronisé, est généré par exemple par un bloc externe au bloc 104,110 et est envoyé sur l'entrée Ti,206. Le signal Scan_sig est, dans cet exemple le signal Scan_reset. L'état du signal Scan_reset se retrouve sur la sortie Z et est distribué vers les autres bascules 302 du circuit 104,110. L'état du signal Synchronous_Functional_reset se retrouve sur la deuxième sortie NSZ et peut être observé sur la bascule de balayage 302 respective.

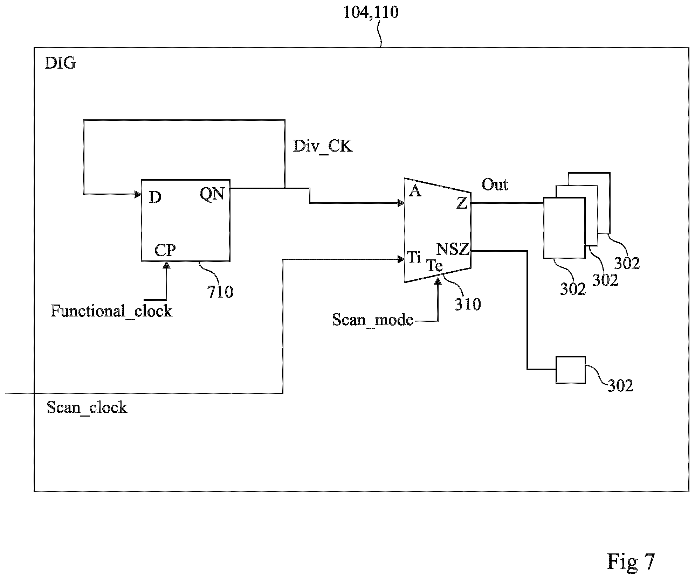

La figure 7 représente de façon schématique un circuit de la figure 1 selon un mode de réalisation.

Plus particulièrement, la figure 7 représente un autre exemple de mise en oeuvre du multiplexeur 310.

Dans l'exemple représenté, le signal Div_CK reçu sur l'entrée A,204 est issu d'un bloc 710 de division de fréquence de signal d'horloge. Le signal Div_CK est, dans cet exemple le signal Functional_sig. Le bloc 710 est par exemple composé d'une ou plusieurs bascules D. Un signal d'horloge Functional_clock est injecté sur l'entrée d'horloge CP de la bascule du bloc 710 et la sortie QN de la bascule est reliée à l'entrée de donnée D du bloc 710. En sortie du bloc 710, le signal d'horloge Functional_clock devient le signal Div_CK ayant une fréquence divisée par rapport à celle du signal Functional_CK.

L'entrée Ti,206 du multiplexeur 310 reçoit un signal Scan_clock généré par exemple à l'extérieur du bloc 104,110 et qui permet le test de la logique des bascules. Le signal Scan_sig est, dans cet exemple le signal Scan_clock.

Lorsque le mode de test est activé, par la mise à l'état haut du signal Scan_mode par exemple, l'état du signal Div_CK se retrouve observable sur la bascule 302 reliée à la deuxième entrée NSZ du multiplexeur 310. En d'autres termes, la sortie NSZ, dans ce cas, fournit de l'observabilité sur la borne d'horloge (clock pin en anglais).

Dans ce mode de test, le signal Scan_clock se retrouve sur la sortie Z et peut être distribué dans le reste du circuit 104,110 par exemple vers d'autres bascules de type à balayage 302.

Divers modes de réalisation et variantes ont été décrits. La personne du métier comprendra que certaines caractéristiques de ces divers modes de réalisation et variantes pourraient être combinées, et d'autres variantes apparaîtront à la personne du métier, en particulier le multiplexeur 310 peut comprendre d'autres sorties que les sorties Z et NSZ, si ces sorties permettent l'observation de signaux qui échappent à la couverture de test.

Enfin, la mise en oeuvre pratique des modes de réalisation et variantes décrits est à la portée de la personne du métier à partir des indications fonctionnelles données ci-dessus. En particulier, les bascules 302, utilisées dans les blocs 104,110 pourront être d'une autre architecture que celle proposée sur la figure 3 du moment qu'elles sont configurées pour pouvoir sélectionner un signal parmi un signal de type Scan_sig et un signal de type Functional_sig en fonction de l'activation ou de la désactivation du mode de test.

## Revendications

1. Circuit électronique de test (200) d'un signal numérique (Functional_sig), le circuit électronique comprenant un circuit de sélection de signal (310) ayant :
- une première entrée (A) destinée à recevoir un signal du circuit numérique à tester ;
- une deuxième entrée (Te) configurée pour recevoir un signal d'activation de mode de test (Scan_mode);
- une troisième entrée (Ti) ;
- une première sortie (Z) destinée à recevoir un état de la troisième entrée (Ti) lorsque la deuxième entrée (Te) est activée et un état de la première entrée (A) lorsque la deuxième entrée (Te) est désactivée ;
- une deuxième sortie (NSZ) destinée à recevoir un état du signal présent sur la première entrée (A) lorsque la deuxième entrée est activée et être mise à zéro lorsque la deuxième entrée (Te) est désactivée.

2. Circuit selon la revendication 1, dans lequel l'état du signal présent sur la deuxième sortie (NSZ) est issu d'une fonction logique de type ET entre l'état du signal d'activation de test et l'état du signal présent sur la première entrée (A) du multiplexeur (310).

3. Circuit selon la revendication 1 ou 2, dans lequel le circuit de test comprend une bascule de balayage (302) comprenant :
- un étage de multiplexage (320) ayant :
une première entrée (315) reliée à la deuxième sortie (NSZ) du multiplexeur (310),
une deuxième entrée (322) configurée pour recevoir l'état du signal d'activation de mode de décalage (Scan_enable),
une troisième entrée (324),
une sortie (332) destinée à recevoir l'état du signal présent sur la première entrée (315) de l'étage de multiplexage (320) lorsque sa deuxième entrée (322) est dans un premier état et recevoir l'état du signal présent sur la troisième entrée (324) de l'étage de multiplexage (520) lorsque sa deuxième entrée (322) est dans un deuxième état ; et
- une bascule de type D (330) dont une entrée de donnée (331) est reliée à la sortie (332) de l'étage de multiplexage (320).

4. Circuit selon la revendication 1 à 3, dans lequel la première sortie (Z) du multiplexeur (310) est reliée à un bloc analogique (108) et l'état du signal sur la troisième entrée (Ti) du multiplexeur (310) est maintenu à un état constant, bas ou haut, au moins lorsque le mode de test est activé.

5. Circuit selon la revendication 1 à 4, dans lequel la première entrée (A) du multiplexeur (310) est reliée à une sortie d'une cellule de synchronisation (610) et la troisième entrée (Ti) du multiplexeur (310) est destinée à recevoir un signal de test de réinitialisation (Scan_reset) généré à l'extérieur du bloc numérique (104,110).

6. Circuit selon l'une quelconque des revendications 1 à 5, dans lequel la première sortie (A) du multiplexeur (310) est reliée à une sortie d'un bloc de division de signal d'horloge (710) et la troisième entrée (Ti) du multiplexeur (310) est destinée à recevoir un signal de test d'horloge (Scan_clock) généré à l'extérieur du bloc numérique (104,110).

7. Circuit selon l'une quelconque des revendications 1 à 6, dans lequel le multiplexeur (210) comprend une première et une deuxième branches (401,402) reliant chacune un premier nœud (N1) à un deuxième nœud (N2) ;
la première branche étant composée de :
deux premiers transistors PMOS (410,412) en série entre le premier nœud (N1) et un troisième nœud (N3),
deux premiers transistors NMOS (414,416) en série entre le troisième nœud (N3) et le deuxième nœud (N2), et
un deuxième transistor PMOS (402) en série avec un deuxième transistor NMOS (404), un nœud de conduction du deuxième transistor PMOS étant relié à un nœud de conduction commun (N6) aux deux premiers transistors PMOS (410,412), et un nœud de conduction du deuxième transistor NMOS étant relié à un nœud de conduction (N8) commun aux deux premiers transistors NMOS (414,416);
la deuxième branche étant composée de deux troisièmes transistors PMOS (418,420) en série entre le premier nœud (N1) et le troisième nœud (N3), et deux troisièmes transistors NMOS (422,424) en série entre le troisième nœud (N3) et le deuxième nœud (N2) ;
le multiplexeur (310) comprenant en outre un quatrième transistors PMOS (428) reliant le premier nœud (N1) à un nœud de conduction (N7) commun aux deuxièmes transistors PMOS et NMOS (402,404).

8. Circuit selon la revendication 7, dans lequel le multiplexeur (310) comprend un premier circuit inverseur (426) configuré pour fournir un état (NTe) inverse de l'état du signal d'activation de mode de test (Scan_mode) sur :
le nœud de commande d'un des premiers transistors NMOS (414) reliant le troisième nœud (N3) au nœud de conduction (N8) commun aux deux premiers transistors NMOS (414,416),
le nœud de commande du deuxième transistors PMOS (402), et
le nœud de commande du troisième transistor PMOS (420) qui est relié au troisième nœud (N3).

9. Circuit selon la revendication 7 ou 8, dans lequel le multiplexeur (210) comprend un deuxième circuit inverseur (456) reliant le nœud de conduction (N7), commun aux deuxièmes transistors PMOS et NMOS (402,404), et la deuxième sortie (NSZ).

10. Circuit selon l'une quelconque des revendications 7 à 9, dans lequel le multiplexeur (310) comprend un troisième circuit inverseur (430) reliant le troisième nœud (N3) et la première sortie (Z).

11. Circuit selon l'une quelconque des revendications 7 à 10, dans lequel le nœud de commande d'un des premiers transistors PMOS (410) ayant un nœud de conduction relié au premier nœud (N1), et le nœud de commande d'un des premiers transistors NMOS (416) ayant un nœud de conduction relié au deuxième nœud (N2) sont destinés à recevoir l'état du signal présent sur la première entrée (A) du multiplexeur (310).

12. Circuit selon l'une quelconque des revendications 7 à 11, dans lequel:
le nœud de commande d'un des premiers transistors PMOS (412) ayant un nœud de conduction relié au troisième nœud (N3),
le nœud de commande du quatrième transistor PMOS (428),
le nœud de commande d'un des troisièmes transistors NMOS (422) relié au troisième nœud (N3), et
le nœud de commande du deuxième transistor NMOS (404), sont destinés à recevoir l'état du signal d'activation de test.

13. Circuit selon l'une quelconque des revendications 7 à 12, dans lequel le nœud de commande d'un des troisièmes transistors PMOS (418) dont un nœud de conduction est relié au premier nœud (N1) et le nœud de commande d'un des troisièmes transistors NMOS (424) relié au deuxième nœud (N2), sont destinés à recevoir l'état du signal présent sur à la troisième entrée (Ti) du multiplexeur (310).

14. Circuit selon l'une quelconque des revendications 1 à 13, dans lequel l'état du signal présent sur la troisième entrée (Ti) du multiplexeur (310) est issu d'un générateur de vecteurs de test (ATPG).

15. Circuit selon l'une quelconque des revendications 1 à 14, dans lequel le circuit électronique de test (200) et le circuit numérique (104,110) sont agencés sur une même puce (100).
